Europäisches Patentamt

European Patent Office

Office européen des brevets

(11) Publication number: **0 062 541**
A1

# EUROPEAN PATENT APPLICATION

(21) Application number: **82301830.4**

(22) Date of filing: **07.04.82**

(51) Int. Cl.³: **H 03 L 7/00, G 11 B 5/09**

(30) Priority: **07.04.81 US 251845**
**07.04.81 US 251805**
**10.07.81 US 251846**

(43) Date of publication of application: **13.10.82**
**Bulletin 82/41**

(84) Designated Contracting States: **DE FR GB IT SE**

(71) Applicant: **Honeywell Information Systems Inc.,**
**200 Smith Street, Waltham Massachusetts 02154 (US)**

(72) Inventor: **Baldwin, David R., 3638 W. Rue de Lamour,**
**Phoenix Arizona (US)**
Inventor: **Lemak, Nicholas S., 3810 West Golden Lane,**
**Phoenix Arizona (US)**

(74) Representative: **Harman, Michael Godfrey et al,**
**Honeywell Control Systems Ltd. Patent Department**
**Charles Square, Bracknell Berks RG12 1EB (GB)**

(54) **Phase-locked oscillators.**

(57) A cumulative count register (213) contains a count representing the mean period of a stream of input pulses. An output counter (215) counts up and cycles repeatedly at this count (reset from comparator 216). An adder (246) determines any deviation of the half-cycle count of counter 215 from the mean count in register (213) at the input pulse, and the resulting error is fed via (221, 204) to adjust the count in register (213) (cycled round via adder 208). Initializing circuitry (207) sets an initial count (for 8 input periods) in counter (213) and sets counter (215) to the mean expected count.

The count at which counter (215) cycles may be varied over successive cycles in dependence on the fractional part of register (213), for long-term enhancement. The counter (215) may be caused to skip a count, or hold a count for a clock cycle in dependence on the error, for short-term enhancement.

## PHASE-LOCKED OSCILLATORS

The present invention relates to phase-locked oscillators, such a circuit producing an output signal which matches, in phase and frequency, an input signal.

In certain types of data transmission system, and data storage system using moving magnetic record media, there is an input stream of pulses which occur at certain ones of a nominally uniformly spaced series of instants. Some of the pulses (or absences of pulses) can be regarded as primarily representing data, and others (or their absence) can be thought of as primarily representing timing signals. In order to interpret the pulses correctly, a timing signal generator is necessary which generates a stream of output pulses which correspond to those timing pulses (or to all pulses) which are present in the input pulse stream, but which also includes additional pulses corresponding to the "missing" pulses in the input pulse stream.

Our application GB 2 000 342 shows a digital timing signal generator for this purpose which comprises a high frequency reference clock oscillator, a frame counter which determines the length of the input pulse stream period, and a programmable counter which counts up to the input pulse period count to generate additional output pulses when input pulses are missing. The frame counter in fact counts the number of reference clock pulses over 8 input pulse periods, to compensate for the effects of missing input pulses and input pulse jitter.

Our application GB 2 039 194 A shows a similar system, in which there is a data rate detector for determining the length of the input period. This includes a rolling 10-frame counter, which counts the number of clock pulses in the last 10 input periods, and a 40-frame average integrator, which contains a count corresponding to 40 frames, and updates this count each 10 frames by taking $\frac{3}{4}$ of the previous count plus the latest count from the rolling 10-frame counter.

- 2 -

These known circuits suffer however from the fact that they are designed primarily to insert missing pulses into the input pulse stream.  While they are successful at this, the input pulse stream may exhibit substantial irregularity in timing, as jitter and sudden phase and frequency changes, and these irregularities are largely reflected in the output pulse stream.

The object of the present invention is to provide a digital phase-locked oscillator circuit in which irregularities in the input pulse stream are substantially smoothed out.

Accordingly the present invention provides digital phase-locked loop circuitry comprising mean count means for determining the mean period of an input pulse sequence as a count of high frequency clock pulses, and a programmable output counter which counts up cyclically to the mean count, characterized in that the output counter is free-running, and by error determining circuitry which generates count correction signals to the mean count means in response to the time of occurrence of output pulses relative to input pulses.

A phase-locked oscillator in accordance with the invention, and two developments thereof, will now be described, by way of example, with reference to the drawings, in which:

Figure 1 is a block diagram of the oscillator;

Figure 2 shows a modification for long term response enhancement; and

Figure 3 shows a modification for short term enhancement.

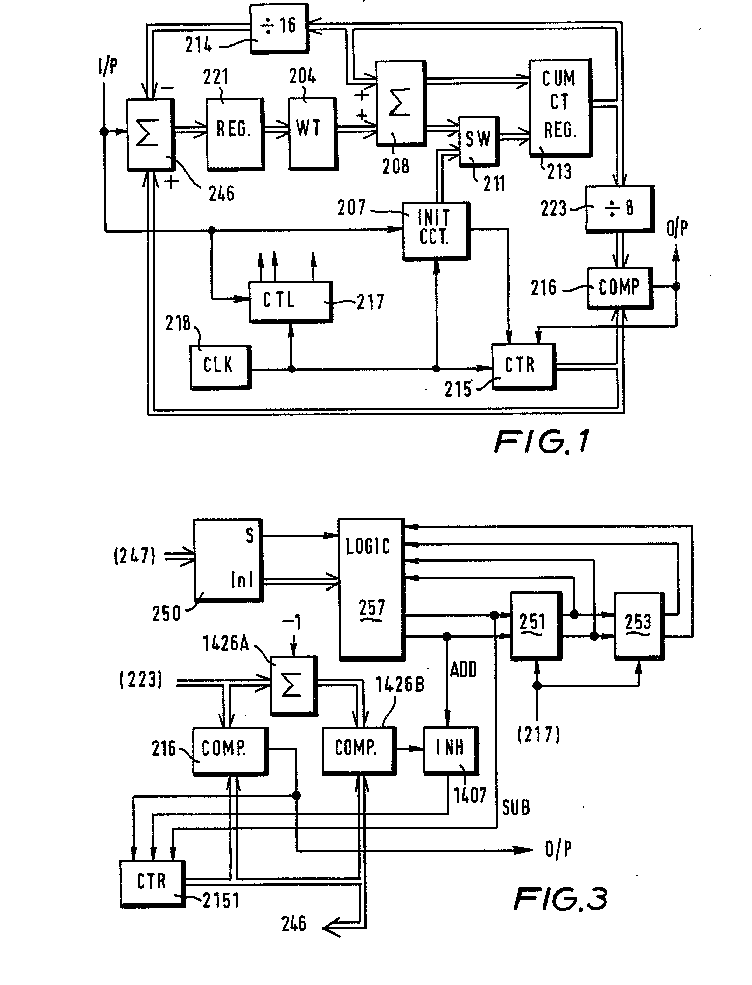

Referring to Figure 1, the basic system has the specific property of being responsive to input pulse signals, and generating output  pulse signals each of which occurs, in the steady state, midway between adjacent input pulses.  The system includes an internal clock signal source 218, which runs at a rate which is 20 times the nominal input pulse frequency.

The system can best be understood by considering first the manner in which the output pulses are generated.  A cumulative count register 213 contains a count of the number of clock pulses occurring over 8 successive input periods. (The manner in which this count is maintained and updated will appear later.) Thus this register will contain a count of about 160. This count is passed through a divide-by-8 circuit 223, to produce a count corresponding to the mean length of a single input period; the fractional part of the output of divider 223 is ignored. An output counter 215 is fed with clock pulses from clock 218, and feeds a comparator 216 which is also fed from divider 223. When the two inputs to the comparator 216 are equal, it produces an output pulse, which is fed back to counter 215 to reset it to 0. Hence the counter 215 counts up repeatedly to the mean length of the input period, and an output pulse is produced each time the counter 216 reaches that count and is reset back to 0.

An initialization circuit 207 is fed from the clock 218 and with the input pulses, and is operative when the system is switched on. The circuit 207 comprises two counters. The first counter counts the number of input pulses, producing an output at a count of 8. The second counter counts clock pulses, and its count is transmitted to a switch 211 when the first counter reaches the count of 8. Thus the initialization circuit 207 counts the number of clock pulses in the first 8 input periods and passes this count on to switch 211. This switch feeds the cumulative count register 208, so that this register is set to contain the length of the first 8 input periods on initialization. Also, the initialization circuit 207 presets the output counter 215 to a count of 10 (half the nominal input period length) on the end of the initial 8 input periods. Thus counter 215 starts its counting with a nominal half period count at the start of the next input period, so that it matches the count from divider 223 about halfway through that next input period. Thus the system is initiated with about the right count in cumulative count register 213 and with the phase of the output pulses about right.

The cumulative count register 213 also feeds a divide-by-16 circuit 214, so that this divider produces a count representing ½ of an input period. The counter 215 is reset at a point nominally halfway through each input period, so its count should be half the input period length when a new input pulse appears. A subtractor 246 subtracts the output of divider 214 from the output of counter 215 on the occurrence of an input pulse. The subtractor 246 therefore produces an error signal indicative of the extent to which the count of counter 215 differs from count corresponding to the midpoint of the input period on the occurrence of the input pulse. This count is fed to a holding register 221.

In practice, the subtractor 246 may be formed by an adder, with the output of divider 214 being complemented (bit by bit) before being fed to the adder, to generate a 1's complement, and a 1 being fed to the carry in input to convert this to a 2's complement. Also, the adder 246 may be unclocked and its output gated into register 221 at the appropriate moment by using the input pulses to clock register 221.

The output of register 221 is fed to a weighting circuit 204, which divides by 2. The purpose of this weighting is to control the rate at which the cumulative count in register 213 responds to discrepancies between the input and output pulse timings. Since register 213 holds a count of 8 times the input period, and the weighting circuit 214 divides the error count (from register 221) by 2, the effective weighting factor is 1/16. The divider factor of the weighting circuit 204 may be made adjustable.

The count in register 213 is fed to an adder 208, to which the output of the weighting circuit 204 is also fed. The input pulses are fed to a control circuit 217, which produces a rapid sequence of control pulses in response to each input pulse. These control pulses are fed to various other units, including the adder 208 (which feeds the register 213) and the register 213, so that when the weighted error count from weighting circuit 204 is available, the count in register 213 is circulated through adder 208, where the weighted error count is added to it, back to register 213.

Two couplings are shown between the adder 208 and register 213. It is convenient to accommodate fractional counts, within limits set by such matters as convenience in the selection of the circuit blocks from commercially available units, and the direct connection from 208 to 213 is for the fractional part of the sum. The integral part of the sum is passed from 208 to 213 via the switch 211, which was also used for the initialization, which of course involves an integral count.

It may be desirable to time the output pulses differently with respect to the input pulses. To some extent, this can be done by changing the divisor of divider 214, so that the output counter 215 reaches its full count either more or less of the way through a full cycle at the moment when the input pulse occurs. This has however the disadvantage that the tolerance of the system is reduced. For example, if the divisor of divider 214 is 32, so that the output pulse occurs nominally 0.75 of the way through the input period, the error count will be wrong if the next actual input pulse occurs over 0.25 of a period late, i.e., after the counter 215 has been reset. This can be corrected for by forming two error counts, one as shown and the other reduced by a further nominal input period count, and selecting the smaller in absolute value.

An alternative is to provide a further comparator and divider, analogous to comparator 216 and divider 223, for generating the output pulses. Comparator 216 and divider 223 will remain for the purpose of resetting the output counter, but the further divider will select a different submultiple of the nominal input period, and the further comparator will produce the output pulse when the output counter reaches that further submultiple. In particular, if the further divider divides by 16 (in which case the divider 214 can be used), the further comparator will produce output pulses timed nominally to coincide with the input pulses.

The choice of factors for the various dividers has been made to simplify the actual dividers, since division by a power of 2 can be achieved simply by a shift of bit positions.

It may also be noted that if an input pulse is missing, no error signal will be produced. Thus the system will continue to run if occasional input pulses are missing, and if the input pulses cease entirely, it will continue to run free at the rate set by the count in the cumulative count register.

The counter 215 cycles when its count equals the output of the divider circuit 223. The divider circuit 223 produces, of course, an integral output, and any fractional part is simply ignored. Thus the count, say n, of counter 215 corresponds to a value band from divider 223 of n to $n+0.111_2$ (binary) (assuming that 3 fractional bits have been dropped). This band can be centred relative to the counter 215 by adding $10_2$ to the output of the cumulative count before applying it to the divider 223, so that the output of the divider is effectively incremented by $0.1_2$.

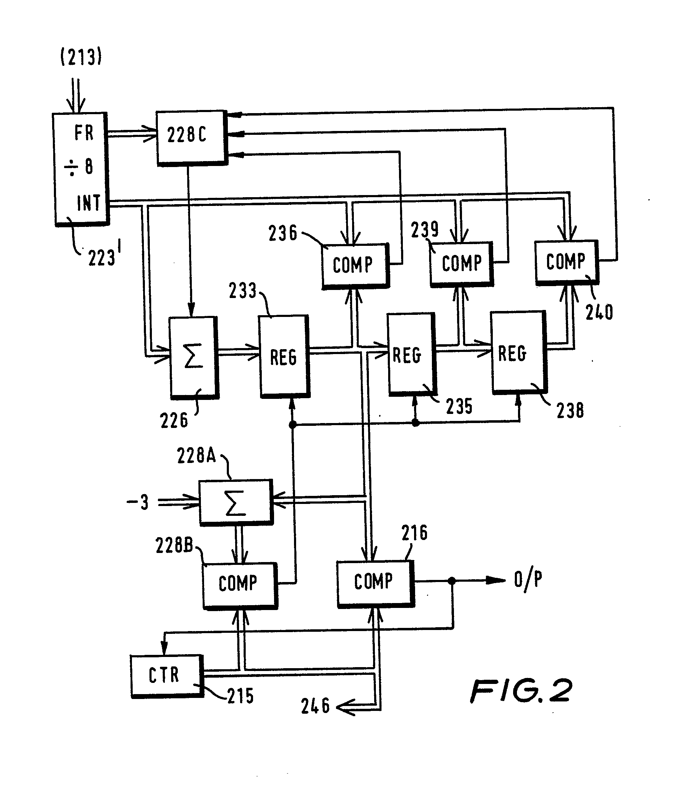

Figure 2 shows a modification of this basic system for enhancement of the long-term behaviour of the system. In place of the divide-by-8 circuit 223, there is an expanded circuit 223', which provides a 2-bit fractional part FR as well as the integer part INT of the cumulative count divided by 8. This integer part INT is fed via an adder 226, which passes the integer part unchanged or incremented by 1, to a series of 3 registers 233, 235, and 238. Thus a total of 4 successive values of the integer part from successive input pulse cycles are available, some of which may have been incremented. The comparator 216 is, in the Figure 2 circuit, fed from the output of register 233.

Register 233 also has its output decremented by 3 by an adder 228A, and the decremented count is fed to a comparator 228B which is also fed by counter 215. Hence comparator 228B produces a pulse 3 clock pulses prior to the output pulse from comparator 216. This output from comparator 228B is used to clock the registers 233, 235, and 238, so advancing the successive cumulative counts along the register chain.

The registers 233, 235, and 238 feed 3 respective comparators 236, 239, and 240 which are also fed direct with the integer part INT of the current cumulative count, so that it is known which of the previous cumulative counts (integral portions) were the same as the current cumulative count (integral portion). These comparators feed a logic circuit 228C, which is also fed with the top 2 bits of the fractional portion FR of the cumulative count from divider 223A. The logic circuit 228C determines when the adder 226 shall increment the integer portion INT by 1.

The logic 228C causes the system to operate as follows. For a fractional part FR of 0.00 (i.e., the $2^{-1}$ and $2^{-2}$ bits are both 0), no incrementing by 1 occurs and the system operates as previously described. For a fractional part of $0.01_2$ (i.e. 0.01 in binary), the integer part INT is incremented by 1 on every 4th cycle. This is done by incrementing it if all three comparators produce 1 outputs; the incremented INT value will then take 3 cycles to pass through the register chain, and prevent another incrementing until it has passed out of the end of the chain. For a fractional part of $0.10_2$, incrementing by 1 occurs on every 2nd cycle. This is done by using the output of comparator 236 to control the incrementing. For a fractional part of $0.11_2$, incrementing is not done on every 4th cycle, but is done on all other cycles. This is done by using all 3 comparator outputs, and incrementing unless all 3 comparator outputs are 1.

The effect of this is that, depending on the fractional part FR of the cumulative count, the output counter 215 is being compared with the actual integral part INT of the cumulative count or 1 greater than this actual value INT on the appropriate proportion of cycles, so that on average the comparison is being carried out to an accuracy of 2 more binary places.

It will be realized that the cumulative count can be adjusted by $0.001_2$ before being fed to the expanded divider 223', to centre the four $0.01_2$ fractional zones, just as an adjustment of $0.1_2$ could be made to the basic Figure 1 system. Also, what is required for the long term enhancement is basically (a) the fractional part of the cumulative count, and (b) historical information over the appropriate number of past cycles as to the adjustments made during those cycles. It would be possible to use a 3-bit shift register to retain the information as to what incrementing had been done in the past 3 cycles, in place of the register chain and associated 3 comparators.

Figure 3 shows a modification of the basic system for enhancement of the short-term behaviour of the system. The error signal from the error register 221 is fed to a circuit 250 which determines the sign S and absolute value $|n|$ of the error. (This circuit 250 may comprise an inverter to form the complement of the error signal, an adder to add 1 to the complement, and a selector to select either the original signal or the incremented complement depending on the sign of the error.) The circuit 250 feeds a logic circuit 257, which has two output lines ADD and SUB which are coupled to an expanded output counter 215'. This counter 215' corresponds to the output counter 215 of the basic system, but has the additional feature that a signal from the ADD or SUB line can cause it to jump a count (i.e count up by 2 instead of 1 for a clock pulse) or to stick at a count (i.e. remain at the same count for a clock pulse). The logic 257 also feeds a chain of two storage circuits 251 and 253, each of which is a 2-bit store, and which are clocked from the control logic 217 so as to store the ADD and SUB signals shortly after they have been generated. Thus the current ADD and SUB signals and those signals for the previous 2 input periods are all available.

The logic 257 causes the sytem to operate as follows. For a positive error, ADD signals are produced, while for a negative error, SUB signals are produced. If an absolute error of 4 or more occurs, then ADD or SUB signals are produced on every input period, so that the output counter 215' cycles either 1 count early or 1 count late on every input period. If the absolute error is 3, then an ADD or SUB signal will be produced on 2 out of every 3 periods. This is done by producing an ADD or SUB signal unless the storage circuits 251 and 253 indicate that ADD or SUB signals were produced on both the previous two periods. If the absolute error is 2, then an ADD or SUB signal is produced on alternate periods. This is done by producing an ADD or SUB signal in the storage circuit 251 indicating that no such signal was produced on the previous period. If the absolute error is 1, then an ADD or SUB signal is produced on every 3rd period. This is done by producing an ADD or SUB signal only if the storage circuits 251 and 253 indicate that no such signal was produced on either of the previous periods. Finally, no ADD or SUB signal is produced if there is no error.

The output of divider 223 is decremented by 1 by an adder 1426A, and this decremented count is compared with the output counter 215' by a comparator 1426B which controls an inhibit circuit 1407 placed in the ADD line between logic 257 and the output counter 215'. This is to ensure that the output counter 215' cannot be incremented by 2 at a point where it would skip over the count from divider 223.

CLAIMS

1. Digital phase-locked loop circuitry comprising mean count means (208,213) for determining the mean period of an input pulse sequence (I/P) as a count of high frequency clock pulses (from 218), and a programmable output counter (215,216) which counts up cyclically to the mean count, characterized in that the output counter (215) is free-running, and by error determining circuitry (246,221,204) which generates count correction signals to the mean count means in resonse to the time of occurrence of output pulses (O/P) relative to input pulses.

2. Circuitry according to Claim 1, characterized by initialization circuitry (207) which sets the output counter (215) to the nominal half-count and counts the length of a predetermined number of input cycles and sets that count in the mean count means on initial operation of the circuitry.

3. Circuitry according to either previous claim, characterized by long term enhancement means (Figure 2) effective to adjust the count at which the output counter cycles in dependence on the fractional part of the mean count and the adjustments made in previous periods.

4. Circuitry according to Claim 3, characterized in that the long term enhancement means comprise a chain of registers (233,235,238) for storing the adjusted mean counts used in previous periods and a corresponding plurality of comparators (236,239,240) for comparing the stored counts with the current mean count.

5. Circuitry according to any previous Claim, characterized by short term enhancement means (Figure 3) effective to adjust the effective count at which the output counter cycles in dependence on the sign and magnitude of the error and the adjustments made in previous periods.

6. Circuitry according to Claim 5, characterized in that the short term enhancement means adjust the count in the output counter.

7. Circuitry according to Claim 6, characterized by means (1426A, 1426B, 1407) which inhibit said adjustment of the count in the output counter when the output counter is near its cycling point.

FIG.1

FIG.3

FIG.2

## European Patent Office

## EUROPEAN SEARCH REPORT

Application number

EP 82 30 1830

| | DOCUMENTS CONSIDERED TO BE RELEVANT | | |
|---|---|---|---|
| Category | Citation of document with indication, where appropriate, of relevant passages | Relevant to claim | CLASSIFICATION OF THE APPLICATION (Int. Cl. ³) |
| A | US-A-3 806 918  (D.L. CAUTHRON et al.) <br> * figures 3,4; column 1, lines 1-22; column 3, line 66 - column 6, line 47 * <br><br> --- | 1,2 | H 03 L    7/00 <br> G 11 B    5/09 |
| A | US-A-4 019 153  (D.B. COX et al.) <br> * figure 1; column 1, lines 5-8; column 5, line 58 - column 6, line 42 * <br><br> --- | 1 | |
| A | US-A-4 206 414  (R.A. CHAPMAN) <br> * figure 1; column 1, lines 9-31; column 2, line 66 - column 3, line 3 * <br><br> --- | 1 | |
| D,A | GB-A-2 039 194  (HONEYWELL) <br> * figures 1-4; page 1, lines 5-21; page 1, line 90 - page 5, line 116 * <br><br> --- | 1 | TECHNICAL FIELDS SEARCHED (Int. Cl. ³) |
| D,A | GB-A-2 000 342  (HONEYWELL) <br><br> ----- | | H 03 L <br> H 04 L <br> G 11 B |

The present search report has been drawn up for all claims

| Place of search | Date of completion of the search | Examiner |
|---|---|---|
| THE HAGUE | 15-07-1982 | RATAJSKI A.A. |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons
 
& : member of the same patent family, corresponding
   document

EPO Form 1503. 03.82